**Europäisches Patentamt**

**European Patent Office**

**Office européen des brevets**

(19)

(11) Veröffentlichungsnummer : **0 298 305 B1**

## (12) EUROPÄISCHE PATENTSCHRIFT

(45) Veröffentlichungstag der Patentschrift :
26.06.91 Patentblatt 91/26

(51) Int. Cl.⁵ : **H05K 7/18, H02B 1/26**

(21) Anmeldenummer : **88109954.3**

(22) Anmeldetag : **22.06.88**

(54) Versteifungsvorrichtung für einen Elektronikschrank.

(30) Priorität : **06.07.87 DE 3722296**

(43) Veröffentlichungstag der Anmeldung :
**11.01.89 Patentblatt 89/02**

(45) Bekanntmachung des Hinweises auf die
Patenterteilung :
**26.06.91 Patentblatt 91/26**

(84) Benannte Vertragsstaaten :
**BE DE ES GB IT NL**

(56) Entgegenhaltungen :
**DE-A- 2 736 163**
**DE-U- 8 101 241**
**FR-A- 2 479 640**

(73) Patentinhaber : **Siemens Aktiengesellschaft**
**Wittelsbacherplatz 2**
**W-8000 München 2 (DE)**

(72) Erfinder : **Brune, Johannes Dipl.-Ing.**
**Am Deckersweiher 4**
**W-8520 Erlangen (DE)**

EP 0 298 305 B1

## Beschreibung

Die Erfindung betrifft eine Versteifungsvorrichtung für einen Elektronikschrank, der aus einem Rahmengestell und daran befestigten Abdeckplatten und wenigstens zwei Türen an der Vorder- oder Rückseite besteht, mit zwei Winkelstreben, die jeweils aus einem stumpfen Winkel einschließenden Profilstäben gebildet sind, deren Schenkelenden im Bereich der oberen und unteren Eckpunkte des Rahmengestells um Achsen schwenkbar befestigt sind, die parallel zu den seitlichen Kanten des Rahmengestells liegen, wobei im eingeschwenkten Zustand die Winkelstreben im Bereich ihrer Scheitel mit einem als Exzenter wirkenden Spannverband kraft- und und formschlüssig miteinander verbunden sind.

Eine derartige Versteifungsvorrichtung ist aus dem DE-GM 81 01 241 bekannt. Bei dieser Versteifungsvorrichtung sind die Winkelstreben im Abstand zu den Türen angeordnet und als Spannverschluß ist im Scheitel einer Winkelstrebe ein Bolzen befestigt, an dem ein Verschlußstück drehbar gelagert ist, das einen exzentrisch verlaufenden Seitenflächenteil aufweist, der in eine ebene Anpreßfläche übergeht. Bei geschlossenem Spannverschluß liegt die Anpreßfläche am einen Scheitel an und die beiden Scheitel werden aneinandergepreßt.

Es besteht die Aufgabe, eine Versteifungsvorrichtung der eingangs genannten Art so weiterzuentwickeln, daß sie sich einfacher handhaben läßt, daß in jedem Fall gewährleistet ist, daß bei geschlossener Tür auch die Versteifungsvorrichtung verspannt ist und daß man einen Formschluß bei der Verspannung über eine größere Fläche erhält.

Erfindungsgemäß wird diese Aufgabe dadurch gelöst, daß die Profilstäbe jeder Winkelstrebe mit einer Tür verbunden sind und die Drehpunkte jeder Winkelstrebe die Drehpunkte der zugehörigen Tür sind, daß als Spannverband im Scheitel der einen Winkelstrebe eine Bohrung des Radius $R_1$ und im Scheitel der anderen Winkelstrebe eine Bohrung des Radius $R_2$ angeordnet ist, wobei der Radius $R_2$ größer als der Radius $R_1$ ist, daß ein aus zwei miteinander verbundenen Scheiben bestehender Spannbolzen vorgesehen ist, wobei die eine Scheibe den Radius $R_1$ aufweist und in der Bohrung mit dem Radius $R_1$ drehbar gelagert ist, wobei die zweite Scheibe im eingeschwenkten Zustand der Winkelstreben in die Bohrung mit dem Radius $R_2$ hineinragt und aus zwei Kreissektoren besteht, von denen einer den Radius $R_2$ und der andere den Radius $R_3$ besitzt und wobei der Mittelpunkt des Kreissektors mit dem Radius $R_2$ auf einer Geraden durch den Mittelpunkt der Scheibe mit dem Radius $R_1$ liegt.

Bei der erfindungsgemäßen Versteifungsvorrichtung sind die Winkelstreben mit den Türen vereint. Damit erhöht sich die nutzbare lichte Weite des Schrankes. Außerdem ist die Handhabung einfacher, da mit einer Drehbewegung des Spannbolzens die Tür vorgespannt und verriegelt ist. Außerdem ist sichergestellt, daß bei geschlossener Tür auch die Versteifungsvorrichtung verspannt ist. Zur Verspannung wird der Spannbolzen um 180° gedreht. Damit kommt der Kreissektor mit dem Radius $R_2$ in Eingriff mit der Bohrung der entsprechenden Winkelstrebe und beide Winkelstreben werden miteinander verspannt.

Vorzugsweise fluchten die beiden Bohrungen im eingeschwenkten, unverspannten Zustand an einer Stelle ihres Umfangs miteinander. Damit erhält man eine besonders einfache Form des Spannbolzens.

Weiterhin ist es vorteilhaft, wenn die Scheibe mit dem radius $R_1$ und der Kreissektor mit dem Radius $R_2$ der zweiten Scheibe den gleichen Mittelpunkt besitzen.

Für die Verspannung der beiden Winkelstreben ist besonders günstig, wenn der Drehpunkt des Spannbolzens im eingeschwenkten, vorgespannten Zustand sich im Schnittpunkt der Schenkel beider Streben befindet.

Günstig für die Formbarkeit des Spannbolzens ist es, den Radius $R_3$ kleiner als den Radius $R_2$ und größer als den Radius $R_1$ zu wählen.

Vorzugsweise ist der Zentriwinkel des Kreissektors mit dem Radius $R_2$ größer als der Winkel, den die Schenkel einer Winkelstrebe einschließen. Damit erhält man im verspannten Zustand eine großflächige Anlage über diesen Winkel, womit man einen besonders sicheren Verschluß erhält.

Auf den Kreissektor mit dem Radius $R_2$ kann ein Vorsprung aufgesetzt sein, der im eingeschwenkten, verspannten Zustand die Winkelstrebe mit der Bohrung mit dem Radius $R_2$ teilweise überdeckt. Der Spannverband ist damit zusätzlich gegen ein zufälliges Aufspringen gesichert.

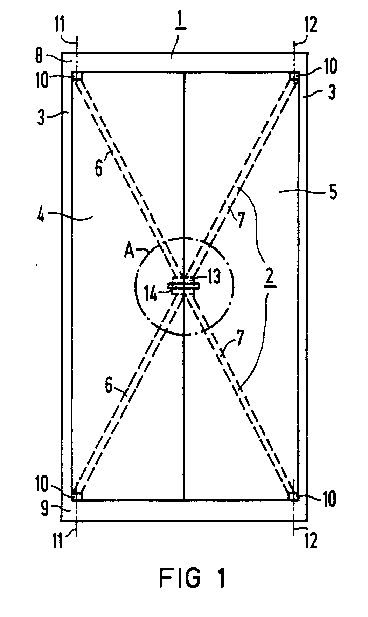

Im folgenden wird die erfindungsgemäße Vorrichtung beispielhaft anhand der Figuren 1 bis 7 näher erläutert. In den Figuren sind gleiche Bauteile mit den gleichen Bezugszeichen versehen.

FIG 1 zeigt einen Elektronikschrank 1 mit einer erfindungsgemäßen Versteifungsvorrichtung 2 im Aufriß. Der Elektronikschrank 1 ist mit einem Rahmengestell 3 aufgebaut, dessen Deck- und Seitenflächen mit Abdeckplatten versehen sind und der an seiner Vorder- und gegebenenfalls auch an seiner Rückseite Türen 4 und 5 besitzt, wie sie in FIG 1 angedeutet sind. Die Versteifungsvorrichtung 2 ist mit einem Paar gleichartig ausgebildeter Winkelstreben 6 und 7 aufgebaut, die aus je zwei Profilstäben bestehen, die einen stumpfen Winkel miteinander bilden. Die Profilstäbe können Hutschienen sein, die jeweils mit einer der Türen 4 oder 5 zu einer Einheit verbunden, beispielsweise verschweißt sind. Die Schenkelenden der beiden Winkelstreben 6 und 7 sind jeweils in einem oberen und unteren Eckpunkt 8 bzw. 9 des Rahmengestells 3 in Lagerblöcken 10 schwenkbar um Achsen 11 und 12 befestigt, die parallel zu den Kanten der Seitenteile des Rahmengestells 3 liegen. Gleichzeitig sind diese Drehpunkte der Winkelstreben 6 und 7 die Drehpunkte der Türen 4 und 5. Zur Drehlagerung können beispielsweise die Profilstäbe der Winkelstreben 6 und 7 an ihren Schenkelenden mit einem Kugelkopf versehen sein, der in der entsprechenden Lagerschale 10 drehbar gehalten ist.

Durch die mechanische Verbindung der Winkelstreben 6 bzw. 7 mit den zugehörigen Türen 4 bzw. 5 erhöht sich die nutzbare lichte Weite des Elektronikschrankes. Außerdem ist sichergestellt, daß bei geschlossener Tür der Spannverband geschlossen und damit auch die Versteifungsvorrichtung verspannt ist.

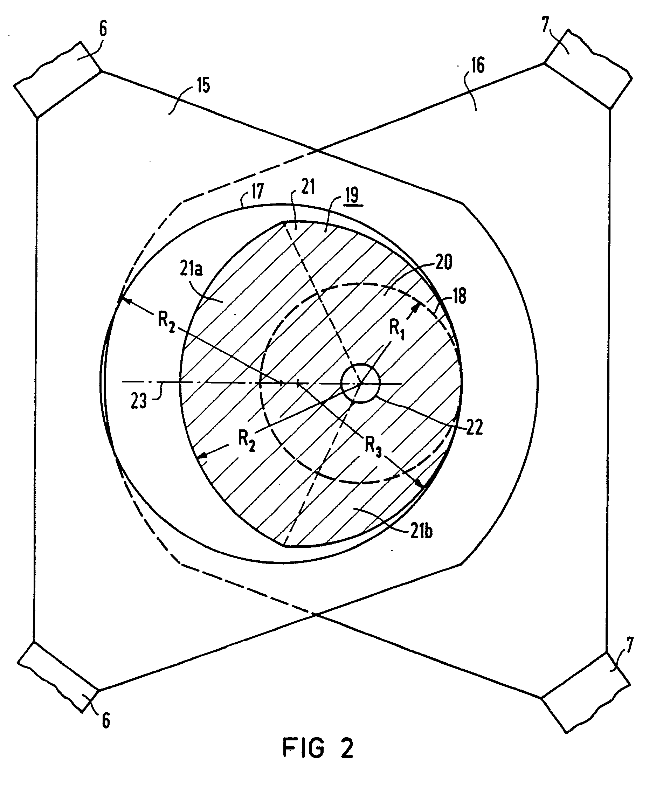

Die beiden Winkelstreben 6 und 7 sind in ihrem Scheitelbereich, der mit dem Kreis A gekennzeichnet ist, mit einem Spannverband 13 kraft- und formschlüssig verbunden. Der Spannverband 13 besitzt eine Handhabe 14, durch deren Drehung die Tür geschlossen und verspannt wird. Bei der Drehung der Handhabe 14 können die Türen zusätzlich über ein Stangenschloß verriegelt werden. Damit erhält man eine einfache Betriebsweise, denn mit einer Drehbewegung der Handhabe 14 ist die Tür vorgespannt und verriegelt. Der Scheitelbereich A ist in den FIG 2 bis 7 im Detail gezeigt und wird im Zusammenhang mit diesen Figuren besprochen werden.

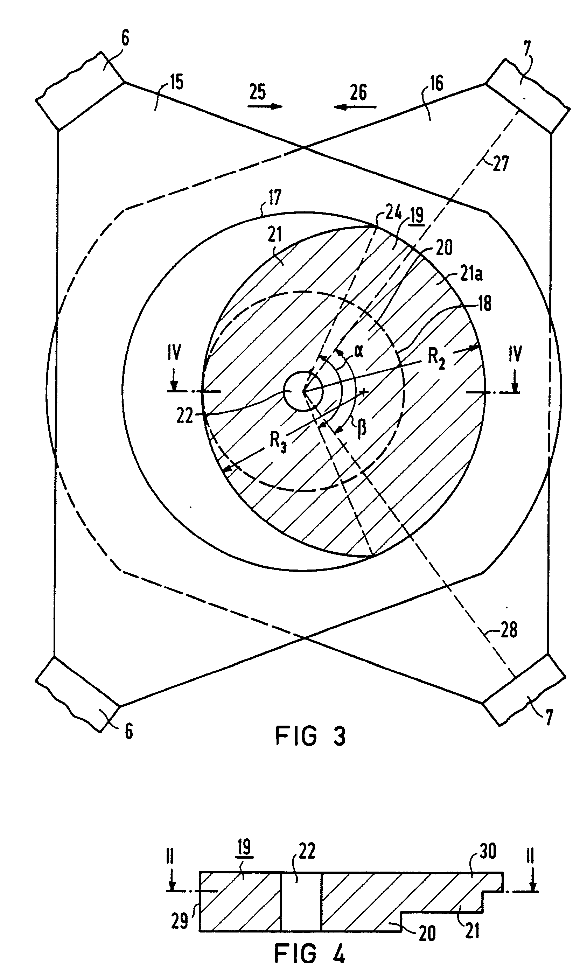

FIG 2 zeigt ein erstes Ausführungsbeispiel des Spannverschlusses 13 im Detail und gleichzeitig eine besondere Ausführungsform des Knotenbereichs A der Versteifungsvorrichtung 2. Dabei ist der Spannverschluß 13 im unverspannten, geschlossenen Zustand der Winkelstreben 6 und 7 gezeigt. Die Winkelstreben 6 bzw. 7 sind in jeweils einem Formstück 15 bzw. 16 verankert, das seinerseits wenigstens teilweise mit der zugehörigen Tür 4 bzw. 5 verbunden ist. Jedes der Formstücke 15 bzw. 16 weist eine Bohrung 17 bzw. 18 auf. Die Bohrung 18 des Formteils 16 besitzt den Radius $R_1$, die Bohrung 17 des Formteils 15 den Radius $R_2$. Dabei ist der Radius $R_2$ größer als der Radius $R_1$. In den beiden Bohrungen 17 und 18 ist ein Spannbolzen 19 angeordnet, der im Schnitt längs der Linie II-II der FIG 4 gezeigt ist. Der Spannbolzen besteht aus zwei Scheiben 20 und 21, wobei die Scheibe 20 den Radius $R_1$ besitzt und in der Bohrung 18 drehbar gelagert ist. Die Scheibe 21 ist aus zwei Kreissektoren zusammengesetzt, von denen der Kreissektor 21a den Radius $R_2$ und der Kreissektor 21b den Radius $R_3$ besitzt. Dabei muß der Radius $R_3$ ebenfalls größer als der Radius $R_1$ sein. Der Spannbolzen 21 besitzt außerdem noch eine Befestigungsmöglichkeit, beispielsweise eine Bohrung 22 für eine Handhabe 14. Die Bohrung 22 liegt im Zentrum der Scheibe mit dem Radius $R_1$.

Die Mittelpunkte der Bohrungen 17 und 18 und der Mittelpunkt des Kreissektors mit dem Radius $R_3$ liegen auf einer Geraden 23. Im Ausführungsbeispiel fallen der Mittelpunkt der Bohrung 18 und der Mittelpunkt des Kreissektors 21a zusammen. Außerdem liegt beim Ausführungsbeispiel auch der Mittelpunkt des Kreissektors 21b mit dem Radius $R_3$ auf der Geraden 23. Dies ist jedoch nicht erforderlich. Weiterhin ist der Radius $R_3$ kleiner als der Radius $R_2$. Auch dies ist nicht erforderlich, führt aber zu einer vereinfachten Form des Spannbolzens 19.

FIG 3 zeigt den Spannverband 13 nach FIG 2 im verspannten Zustand. Der Spannbolzen 19 wurde um 180° gedreht. Dabei kam die Kante 24 des Spannbolzens, an der der Kreissektor 21a mit dem Kreissektor 21b aneinanderstoßen, in Eingriff mit der Bohrung 17 und die Formteile 15 und 16 wurden in Richtung der Pfeile 25 und 26 bewegt, bis der Kreissektor 21a der den Radius $R_2$ besitzt, an der Bohrung 17 anliegt. Damit sind die beiden Winkelstreben 6 und 7 gegeneinander verspannt, wobei ihre Kraftlinien 27 und 28 durch den Mittelpunkt der Bohrung 18 führen. Der Kreissektor 21a liegt mit einer großen Fläche an der Bohrung 17 an. Im Ausführungsbeispiel ist der Zentriwinkel $\alpha$ des Kreissektors 21a größer als der Winkel $\beta$, den die Wirklinien 27 und 28 der Profilstäbe der Winkelstrebe 7 miteinander bilden. Dieser große Formschluß gewährleistet eine stabile Verspannung der beiden Winkelstreben 6 und 7.

FIG 4 zeigt einen Schnitt längs der Linie IV-IV durch den Spannbolzen 19. Die Kreisscheibe 20 und die Scheibe 21 besitzen eine gemeinsame Kante 29, was der Tatsache entspricht, daß die Bohrungen 17 und 18 im unverspannten Zustand an einer Stelle ihres Umfangs miteinander fluchten. Auf die Scheibe 21 ist eine weitere Scheibe 30 aufgesetzt, die im Bereich des Kreissektors 21a über die Scheibe 21 hinausragt. Dieser Vorsprung 30 liegt im verspannten Zustand auf dem Formteil 15 auf und verhindert auch ein zufälliges Öffnen des Spannverbandes 13.

Im Ausführungsbeispiel nach den FIG 2 bis 4 ist im geschlossenen Zustand für die Verspannung die Differenz zwischen dem Radius $R_2$ und dem Radius $R_1$ maßgebend. Für die größte Verspannung während des Drehens des Zapfens 19 ist der Winkel maßgebend.

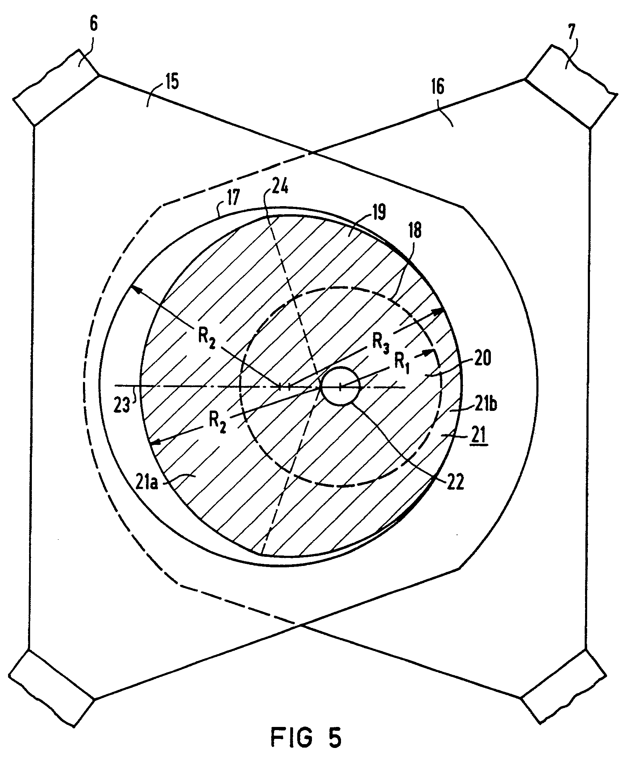

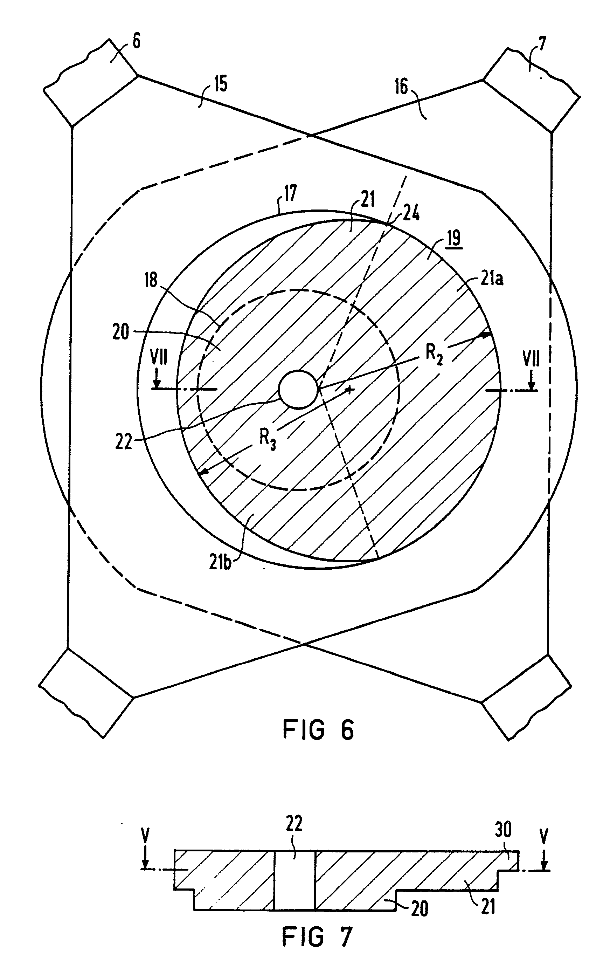

In den FIG 5 bis 7 ist ein weiteres Ausführungsbeispiel des erfindungsgemäßen Spannverbandes dargestellt. In diesem Ausführungsbeispiel, das sonst dem Ausführungsbeispiel der FIG 2 bis 4 entspricht, fällt der Mittelpunkt des Kreissektors 21a mit dem Radius $R_2$ nicht mehr mit dem Mittelpunkt der Kreisscheibe 20 zusammen. Die Mittelpunkte der Bohrungen 17 und 18 und der Mittelpunkt des Kreissektors 21a liegen aber weiterhin auf einer Geraden 23. Die Funktion des Spannbolzens 19 verändert sich damit nicht gegenüber dem Ausführungsbeispiel nach den FIG 2 bis 4. Wie der Schnitt durch den Spannbolzen 19 nach FIG 7 zeigt, ist lediglich dessen Form etwas komplizierter zu fertigen.

## Ansprüche

1. Versteifungsvorrichtung für einen Elektronikschrank, der aus einem Rahmengestell und daran befestigten Abdeckplatten und wenigstens zwei Türen an der Vorder- oder Rückseite besteht, mit zwei Winkelstreben, die jeweils aus einem stumpfen Winkel einschließenden Profilstäben gebildet sind, deren Schenkelenden im Bereich der oberen und unteren Eckpunkte des Rahmengestells um Achsen schwenkbar befestigt sind, die parallel zu seitlichen Kanten des Rahmengestells liegen, wobei im eingeschwenkten Zustand die Winkelstrebe im Bereich ihrer Scheitel mit einem als Exzenter wirkenden Spannverband kraft-und und formschlüssig miteinander verbunden sind, **dadurch gekennzeichnet,** daß die Profilstäbe jeder Winkelstrebe (6, 7) mit einer Tür (4, 5) verbunden sind und die Drehpunkte (10) jeder Winkelstrebe (6, 7) die Drehpunkte der zugehörigen Tür (4, 5) sind, daß als Spannverband (13) im Scheitel der einen Winkelstrebe (7) eine Bohrung (18) des Radius $R_1$ und im Scheitel der anderen Winkelstrebe (6) eine Bohrung (17) des Radius $R_2$ angeordnet ist, wobei der Radius $R_2$ größer als der Radius $R_1$ ist, daß ein aus zwei miteinander verbundenen Scheiben (20, 21) bestehender Spannbolzen (19) vorgesehen ist, wobei die eine Scheibe (20) den Radius $R_1$ aufweist und in der Bohrung (18) mit dem Radius $R_1$ drehbar gelagert ist, wobei die zweite Scheibe (21) im eingeschwenkten Zustand der Winkelstreben (6, 7) in die Bohrung (17) mit dem Radius $R_2$ hineinragt und aus zwei Kreissektoren (21a, 21b) besteht, von denen einer (21a) den Radius $R_2$ und der andere (21b) den Radius $R_3$ besitzt und wobei der Mittelpunkt des Kreissektors (21a) mit dem Radius $R_2$ auf einer Geraden durch den Mittelpunkt der Scheibe (18) mit dem Radius $R_1$ liegt.

2. Versteifungsvorrichtung nach Anspruch 1, **dadurch gekennzeichnet,** daß die beiden Bohrungen (17, 18) im eingeschwenkten, unverspannten Zustand an einer Stelle ihres Umfangs miteinander fluchten.

3. Versteifungsvorrichtung nach Anspruch 1 oder 2,**dadurch gekennzeichnet,** daß die Scheibe (20) mit dem Radius $R_1$ und der Kreissektor (21a) mit dem Radius $R_2$ der zweiten Scheibe (21) den gleichen Mittelpunkt besitzen.

4. Versteifungsvorrichtung nach einem der Ansprüche 1 bis 3, **dadurch gekennzeichnet,** daß der Drehpunkt des Spannbolzens (19) im eingeschwenkten, verspannten Zustand sich im Schnittpunkt der Schenkel beider Winkelstreben (6, 7) befindet.

5. Versteifungsvorrichtung nach einem der Ansprüche 1 bis 4, **dadurch gekennzeichnet,** daß der Radius $R_3$ kleiner als der Radius $R_2$ und größer als der Radius $R_1$ ist.

6. Versteifungsvorrichtung nach einem der Ansprüche 1 bis 5, **dadurch gekennzeichnet,** daß

der Zentriwinkel ($\alpha$) des Kreissektors (21a) mit dem Radius $R_2$ größer als der Winkel ($\beta$) ist, den die Schenkel einer Winkelstrebe (6 oder 7) einschließen.

7. Versteifungsvorrichtung nach einem der Ansprüche 1 bis 6, **dadurch gekennzeichnet,** daß auf den Kreissektor (21a) mit dem Radius $R_2$ ein Vorsprung (30) aufgesetzt ist, der im eingeschwenkten Zustand die Winkelstrebe (6) mit der Bohrung (17) mit dem Radius $R_2$ teilweise überdeckt.

## Claims

1. Stiffening device for an electronics cabinet, which cabinet consists of a frame rack and covering plates attached thereto and at least two doors on the front or rear side, the stiffening device having two angle struts which are each formed by profile bars enclosing an obtuse angle, the ends of the sides of which profile bars are pivotably attached, in the region of the upper and lower joints of the frame rack, around axes which are located parallel to side edges of the frame rack, the angle struts being connected together in friction-locked and form-locked manner, in the inward-pivoted state, in the region of their apex, by a tensioning brace acting as an eccentric, **characterised in that** the profile bars of each angle strut (6, 7) are connected to a door (4, 5) and the pivots (10) of each angle strut (6, 7) are the pivots of the associated door (4, 5), and in that, as a tensioning brace (13), a hole (18) with radius $R_1$ is arranged in the apex of the one angle strut (7) and a hole (17) with radius $R_2$ is arranged in the apex of the other angle strut (6), the radius $R_2$ being greater than the radius $R_1$, and in that there is provided a tension bolt (19) consisting of two discs (20, 21) connected together, the one disc (20) having radius $R_1$ and being rotatably mounted in the hole (18) with radius $R_1$, the second disc (21) projecting, in the inward-pivoted state of the angle struts (6, 7), into the hole (17) with radius $R_2$, and this second disc (21) consisting of two circular sectors (21a, 21b), one (21a) of which possesses radius $R_2$ and the other (21b) of which possesses radius $R_3$, the central point of the circular sector (21a) with radius $R_2$ being located on a straight line through the central point of the disc (18) with radius $R_1$.

2. Stiffening device according to claim 1, **characterised in that** the two holes (17, 18) align with each other at a point on their circumference in the inward-pivoted, unbraced state.

3. Stiffening device according to claim 1 or 2, **characterised in that** the disc (20) with radius $R_1$ and the circular sector (21a) with radius $R_2$ of the second disc (21) possess the same central point.

4. Stiffening device according to one of claims 1 to 3, **characterised in that** the pivot of the tension bolt (19) is located, in the inward-pivoted, braced state, in the intersection of the sides of the two angle struts (6, 7).

5. Stiffening device according to one of claims 1 to 4, **characterised in that** the radius $R_3$ is smaller than the radius $R_2$ and larger than the radius $R_1$.

6. Stiffening device according to one of claims 1 to 5, **characterised in that** the central angle ($\alpha$) of the circular sector (21a) with radius $R_2$ is larger than the angle ($\beta$) enclosed by the sides of an angle strut (6 or 7).

7. Stiffening device according to one of claims 1 to 6, **characterised in that,** attached to the circular sector (21a) with radius $R_2$, there is a projection (30) which, in the inward-pivoted state, partially covers the angle strut (6) having the hole (17) with radius $R_2$.

## Revendications

1. Dispositif raidisseur pour une armoire électronique, constituée par un châssis en forme de cadre et des plaques de fermeture, fixées à ce châssis, et au moins deux portes situées sur la face avant ou sur la face arrière, et comportant au moins deux entretoises coudées, qui sont formées chacune par des barres profilées qui font un angle obtus et dont les extrémités des branches sont fixées de manière à pouvoir pivoter, au niveau des coins supérieurs et inférieurs du châssis en forme de cadre, autour d'axes qui sont parallèles à des bords latéraux du châssis en forme de cadre, auquel cas, à l'état rentré par pivotement, les entretoises coudées sont reliées entre elles selon une liaison de force et selon une liaison par formes complémentaires, au niveau de leur sommet, par une unité de serrage agissant à la manière d'un excentrique, caractérisé par le fait que les barres profilées de chaque entretoise coudée (6, 7) sont raccordées à une porte (4, 5) et que les centres de rotation (10) des entretoises coudées (6, 7) sont les centres de rotation des portes associées (4, 5), qu'il est prévu comme unité de serrage (13), au sommet d'une entretoise coudée (7), un perçage (18) de rayon $R_1$ et, au sommet de l'autre entretoise coudée (6), un perçage (17) de rayon $R_2$ supérieur au rayon $R_1$, qu'il est prévu un boulon de serrage (19) constitué par deux disques (20, 21) reliés entre eux et dont l'un (20) possède le rayon $R_1$ et est monté rotatif dans le perçage (18) de rayon $R_1$, tandis que le second (21) pénètre, lorsque les entretoises coudées (6, 7) sont pivotées à l'état rentré, dans le perçage (17) de rayon $R_2$ et est constitué par deux secteurs circulaires (21a, 21b), dont l'un (21a) possède le rayon $R_2$ et l'autre (21b) le rayon $R_3$, le centre du secteur circulaire (21a) de rayon $R_2$ étant situé sur une droite passant par le centre du perçage (18) de rayon $R_1$.

2. Dispositif raidisseur suivant la revendication 1, caractérisé par le fait qu'à l'état rentré par pivotement et non tendu, les deux perçages (17, 18) sont alignés entre eux au niveau d'une partie de leur pourtour.

3. Dispositif raidisseur suivant la revendication 1 ou 2, caractérisé par le fait que le disque (20) de rayon $R_1$ et le secteur circulaire (21a) du rayon $R_2$ du second disque (21) ont des centres confondus.

4. Dispositif raidisseur suivant l'une des revendications 1 à 3, caractérisé par le fait qu'à l'état rentré par pivotement et serré, le centre de rotation du boulon de serrage (19) est situé au centre des branches des deux entretoises coudées (6, 7).

5. Dispositif raidisseur suivant l'une des revendications 1 à 4, caractérisé par le fait que le rayon $R_3$ est inférieur au rayon $R_2$ et est supérieur au rayon $R_1$.

6. Dispositif raidisseur suivant l'une des revendications 1 à 5, caractérisé par le fait que l'angle au centre ($\alpha$) du secteur circulaire (21a) de rayon $R_2$ est supérieur à l'angle ($\beta$) que font les branches d'une entretoise coudée (6 ou 7).

7. Dispositif raidisseur suivant l'une des revendications 1 à 6, caractérisé par le fait que sur le secteur circulaire (21a) de rayon $R_2$ est prévue une partie saillante (3) qui, à l'état rentré par pivotement, recouvre en partie l'entretoise coudée (6) possédant le perçage (17) de rayon $R_2$.

FIG 1

FIG 2

EP 0 298 305 B1

FIG 3

FIG 4

8

FIG 5

FIG 6

FIG 7